# EUROPÄISCHE PATENTSCHRIFT

(11) **EP 0 744 848 B1**
(45) Veröffentlichungstag und Bekanntmachung des Hinweises auf die Patenterteilung: **03.04.2002**
(21) Anmeldenummer: 96107157.8
(22) Anmeldetag: 07.05.1996
(51) Int. Cl.: H04L 7/02, H04L 25/03, H03M 13/23

(54) **Synchronisierung eines Viterbi Detektors mit Rückkoppelung zur Abtaststufe**
Synchronisation of Viterbi detector with feedback to sampling means
Synchronisation d'un détecteur Viterbi avec rétroaction vers l'échantillonneur

(30) Priorität: 16.05.1995 DE 19517405
(43) Veröffentlichungstag der Anmeldung: 27.11.1996
(73) Patentinhaber: DEUTSCHE THOMSON-BRANDT GMBH, 78048 Villingen-Schwenningen (DE)
(72) Erfinder: Kaaden, Jürgen, 78052 Villingen-Schwenningen (DE); Reiner, Gerhard, 78052 Villingen Schwenningen (DE); Bräuer, Dietmar, 78052 Villingen-Schwenningen (DE)

(56) Entgegenhaltungen:
- EP-A- 0 504 905
- DE-A- 4 308 000
- US-A- 3 872 432
- US-A- 4 675 871
- ELECTRONICS LETTERS, Bd. 25, Nr. 2, 19.Januar 1989, Seite 152/153 XP000047686 "CODE-ASSISTED BIT SYNCHRONISATION (CABS) SCHEME"

## Beschreibung

**Die Erfindung geht aus von einer Vorrichtung zur Wiedergewinnung von digitalen Daten aus einem aufgezeichnetem Signal** gemäß dem Oberbegriff des Anspruchs 1.

Bei digitalen, magnetischen und optischen Speichersystemen für audio/video/data werden im Wiedergabebetrieb PLL (Phase Locked Loop) Systeme zur Rücksynchronisation des Taktes aus den Daten eingesetzt. In diesen Systemen sind zur Rückwandlung der digitalen Daten aus den analog abgetasteten Signalen Entscheider vorgesehen, die bei den neuartigen Systemen wie DVC (Bandaufzeichnung) oder DVD (optische Wiedergabe) in selbstadaptierender, auf den Speichermediumtyp optimal angepaßter Form als Viterbi-Detektor ausgeführt sind. Der Viterbi-Detektor arbeitet im Regelfall digital, d.h. das analog vorliegende Signal wird mit Hilfe eines A/D (Analog-/Digital) Wandlers digitalisiert und dem Detektor zugeführt.

Nachteilig hierbei ist, daß der Abtastzeitpunkt beeinflußt wird vom Verhalten der PLL und der Entzerrung. Er ist ferner abhängig von Verzerrungen, die bei der Aufnahme entstanden sind, sowie vom thermischen Verhalten der Elektronik. In der Realität ist mit einer Varianz von etwa 10% zu rechnen. Ein nicht optimaler, "augenmittiger" Abtastzeitpunkt jedoch führt zu vermehrten Fehlentscheidungen im Viterbi-Detektor, die er bis zu einem gewissen Grad selbsttätig korrigiert. Die Fehlerkorrektur wird in aller Regel den verbleibenden Rest korrigieren, wobei im Falle von zusätzlichen Amplitudeneinbrüchen durch Bandkratzer oder Fehlstellen im Band die Korrekturkapazität schnell überschritten werden kann. Datenverlust ist dann die Folge.

Aus der EP-A-0 504 905 ist ein Empfangsgerät für digital modulierte Satellitensignale bekannt, bei dem ein Faltungsdekoder vorgesehen ist, der das demodulierte Signal auswertet. Die im Faltungsdekoder festgestellte Fehlerrate wird mit einem Schwellwert verglichen. Wenn die Fehlerrate den Schwellwert überschreitet, wird ein Steuersignal generiert, das eine Änderung der Demodulationsfrequenzen bewirkt.

Aus der DE-A-43 08 000 (A) ist ein Empfangsgerät mit einem Demodulator, einer Abtaststufe und einem Viterbi Dekodierer bekannt. Durch einen Vergleich der Eingangs- und Ausgangssignale des Viterbi-Dekodierers wird ein Phasenfehler errechnet, aus dem ein Signal zur Erhöhung, Reduzierung oder gebebenenfalls zum Halten der Abtastfrequenz abgeleitet wird.

Aus der US-A-3 872 432 ist eine Synchronisationsschaltung für einen Viterbi-Dekoder bekannt.

In dem Artikel "Code-assisted bit synchronisation (CABS) scheme" in Electronics Letters Band 25, Nr. 2, 19. Jan. 1989, Seite 152-153 ist eine Lösung beschrieben, mit der die Aufgaben Bit-Synchronisation und Fehlerkorrektur in einem Bearbeitungsschritt gleichzeitig erledigt werden können.

Der Erfindung liegt die Aufgabe zugrunde, den Abtastzeitpunkt des Gesamtsystemes zu verbessern. Diese Aufgabe wird durch die im Anspruch 1 angegebenen Merkmale der Erfindung gelöst. Vorteilhafte Weiterbildungen der Erfindung sind in den Unteransprüchen angegeben.

Erfindungsgemäß wird der im System vorhandene Viterbi-Detektor um einen Steuerausgang erweitert, womit eine variable Verzögerungsleitung am Ausgang oder innerhalb der PLL gesteuert wird.

Ein Algorithmus, der die schon angesprochenen Fehlentscheidungen zählt und innerhalb eines definierten Zeitintervalles gestartet wird, **kann wie folgt aussehen:**

Beim Überschreiten einer vorbestimmten Anzahl von korrigierten Fehlentscheidungen/Zeitintervall wird die Optimierung des Abtastzeitpunktes wie folgt durchgeführt:
(a) eine definierte Umschaltung auf einen neuen Verzögerungswert wird vorgenommen. Die Veränderung der Fehlentscheidungen wird ausgewertet.
   Bei einer Verbesserung wird der nächste Verzögerungswert in der gleichen Wirkrichtung getestet, bei einer Verschlechterung wird die Wirkrichtung umgeschaltet.
(b) das Auftreten von Fehlentscheidungen wird nicht nur im Betrag sondern auch in der Position , bezogen auf den jeweiligen Flankenwechsel, registriert.
   Bei Fehlerhäufung an einer bestimmten Flanke werden in der kompensierenden Richtung solange neue Verzögerungswerte getestet, bis ein Optimum vorliegt.

Nach der Ermittlung eines Optimums wird dieser Wert beibehalten, bis die Summe der Fehlentscheidungen/Zeitintervall eine Neuoptimierung startet.

Signalverarbeitungssystem für digitale Signale bestehend aus einer Taktrückgewinnungsstufe, einer getakteten Abtaststufe und einem Viterbi-Detektor als Entscheiderstufe.

Die Phase der Abtastung wird durch den Steuerausgang des Viterbi-Detektors so verschoben, daß die Abtastposition in der Augenöffnungsposition erfolgt, die der minimalen Fehlerrate entspricht.

Die Fehlerrateninformation wird aus der Summe der im Viterbi-Detektor ermittelten und korrigierten Fehlentscheidungen pro Zeiteinheit gewonnen.

Die Optimierung wird bei Überschreitung eines vorbestimmten hohen Fehlerwertes automatisch gestartet und bei Unterschreiten eines vorbestimmten niedrigen Fehlerwertes automatisch beendet, **wonach** der zuletzt ermittelte Ausgabewert beibehalten **wird.** Die Optimierung ist ständig aktiviert. Das System wird mit einem Mittelwert gestartet oder das System startet mit dem zuletzt ermittelten, gespeicherten Ausgabewert.

Der Viterbi-Detektor der über Steuerausgänge verfügt, verändert die Taktphase am Eingang der Abtaststufe. Zwischen Taktrückgewinnung und Abtastung ist eine schaltbare Verzögerungsleitung vorhanden, die vom Viterbi-Detektorausgang gesteuert wird. Die Phase der Täktrückgewinnung wird durch Einspeisung eines Phasenoffsets direkt verändert, der über einen Digital-/Analogwandler vom Viterbi-Detektorausgang gesteuert wird. Die Abtaststufe beinhaltet einen Analog-/Digitalwandler.

Der Optimierungsvorgang ist durch Auswertung jedes fehlerhaften Pegelüberganges iterativ aufgebaut, indem nach Einschalten einer veränderten Abtastposition das Fehlerergebnis ausgewertet und die entsprechende nächste Aktion gestartet wird.

Anwendungsbereiche sind **alle Systeme**, die über eine PLL zur Datensynchronisation, sowie eine digitale Signalabtastung und einen Viterbi-Detektor verfügen. Insbesondere in:
Empfängern für digitale Übertragungssysteme (DVB, DSS, ATV,...),
Wiedergabeelektroniken optischer Speichersysteme (HDCD, DVD),
Wiedergabeelektroniken magnetischer Speichersysteme
Schrägspuraufzeichnung (DVC-digital video cassette)
Längsspuraufzeichnung (SDCR-stationary digital cassette recorder)
Datenaufzeichnung (HDD-hard disk drive)

Die Erfindung wird im folgenden anhand der Zeichnung erläutert. Darin zeigen
- Fig. 1: eine fehlerhafte Dekodierung des DVC Datensignals,
- Fig. 2: stellt das Blockschaltbild der erfindungsgemäßen Lösung dar,
- Fig. 3: stellt ein ternäres, korrekt entzerrtes PR4-Signal, wie bei DVC verwendet und
- Fig. 4: stellt die Struktur innerhalb des Viterbi-Detektors dar.

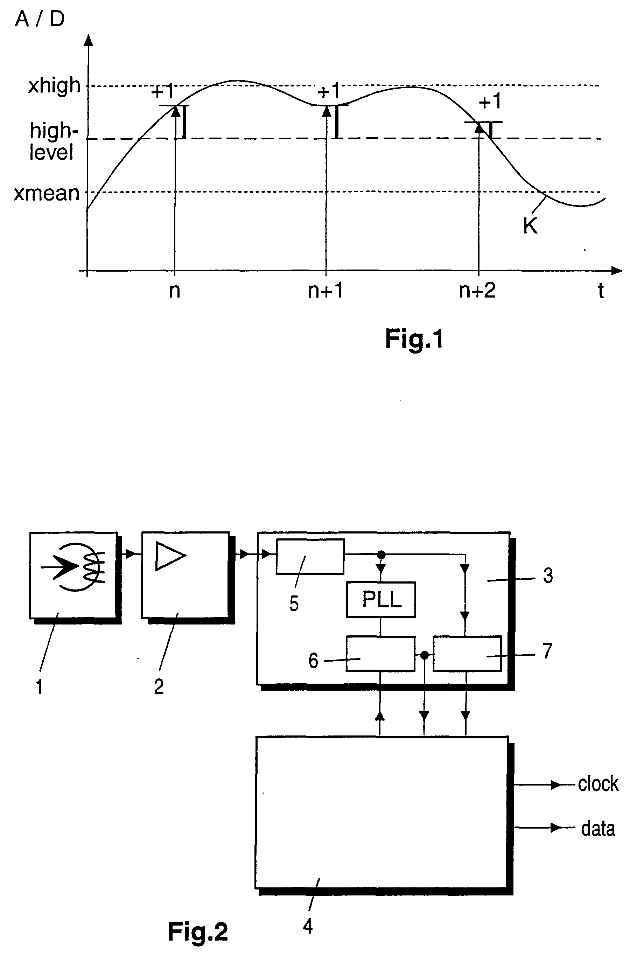

Fig. 1 zeigt eine fehlerhafte Dekodierung des DVC-Datensignals. Es sind dargestellt die Abtastzeitpunkte n, n+1 und n+2 auf der Zeitachse T und die analog/digital Wandlerwerte A/D mit den markierten Punkten x-high, high level und x-mean. Weiterhin ist der Kurvenverlauf K dargestellt.

Die Darstellung bezieht sich auf ein ternäres Signalschema, bei dem Flankenwechsel als +1 bzw. -1 dargestellt werden und der mittlere Pegel den Wert 0 aufweist. Der Kurvenzug stellt einen +1 Signalsprung dar, etwaige Rauschanteile sind ausgeblendet.

Hierbei stellt xmean den mittleren Pegelwert dar, der zwischen Flankenwechseln auftritt und dem Wert 0 entspricht. Der Bereich high-level markiert **einen Bereich** oberhalb dessen ein Puls als +1 erkannt wird.
Der Mittelwert xhigh stellt den +1 Pegel dar. (Folgerichtig existieren die Wertegrenzen low-level und xlow zur Auswertung der -1 Signalsprünge). Vorgegeben durch Vorkodierung **bei der** Aufzeichnung sind nur maximal 2 aufeinanderfolgende +1 bzw. -1 Werte erlaubt. Im konkret dargestellen Fall wird der Viterbi-Detektor nach Prüfung der Pegelverhältnisse auf einen fehlerhaften Puls zum Zeitpunkt n+2 schließen. Gleichzeitig wird dieser Fehler **der fallenden** Flanke zugeordnet um eine eindeutige Regelrichtungserkennung zu ermöglichen.

Fig. 2 zeigt den Wiedergabekopf 1 den Wiedergabeverstärker 2 eine Bauelementeneinheit 3 und den Viterbi-Detektor 4 mit den Ausgängen clock und data. Die Bauelementeeinheit 3 besteht aus einem Equalizer 5 einer PLL-Schaltung PLL, einem Phasenschieber 6 und einem A/D-Wandler 7.

Der Wiedergabekopf liest das Signal vom Band, das im nachfolgenden Wiedergabeverstärker auf einen Pegel von mehreren 100 mV gebracht wird. Der Equalizer kompensiert höherfrequente Pegelverluste und beinhaltet eine Gruppenlaufzeitkorrektur. An dessen Ausgang stehen Signale gemäß Fig. 1 zur Verfügung. Die PLL-Schaltung wird durch Signalflankenwechsel angesteuert, deren Zeitpunkte mit den Flankenwechseln eines nicht dargestellten, spannungsgesteuerten Oszillators verglichen und synchronisiert werden. Am Ausgang der PLL schließt sich eine in ns Schritten schaltbare Verzögerungsleitung an. Deren Ausgang speist den Takteingang eines A/D-Wandlers, an dessen Eingang das aus dem Equalizer kommende Signal anliegt. Die Ausgangssignale des Wandlers werden dem Viterbi-Detektor zugeführt. Dieser wiederum stellt an einem Ausgang den Korrekturwert für die Taktverzögerung bereit, an einem weiteren Ausgang ist das entschiedene und auf den Takt synchronisierte Datensignal verfügbar.

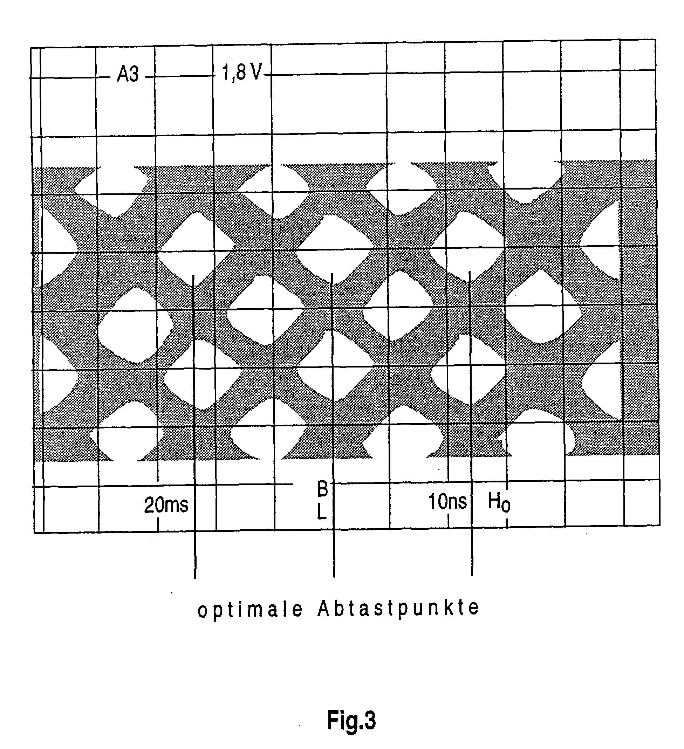

Fig. 3 stellt ein Bild eines Oszillographen mit den optimalen Abtastzeitpunkten dar. Die Darstellung stellt das über einen längeren Zeitraum kontinuierlich gemessene Ausgangssignal des Equalizers dar. Dies ist das Augendiagramm eines ternären Signales. Für minimale Fehlerrate muß im Zeitpunkt der maximalen Augenöffnung abgetastet werden.

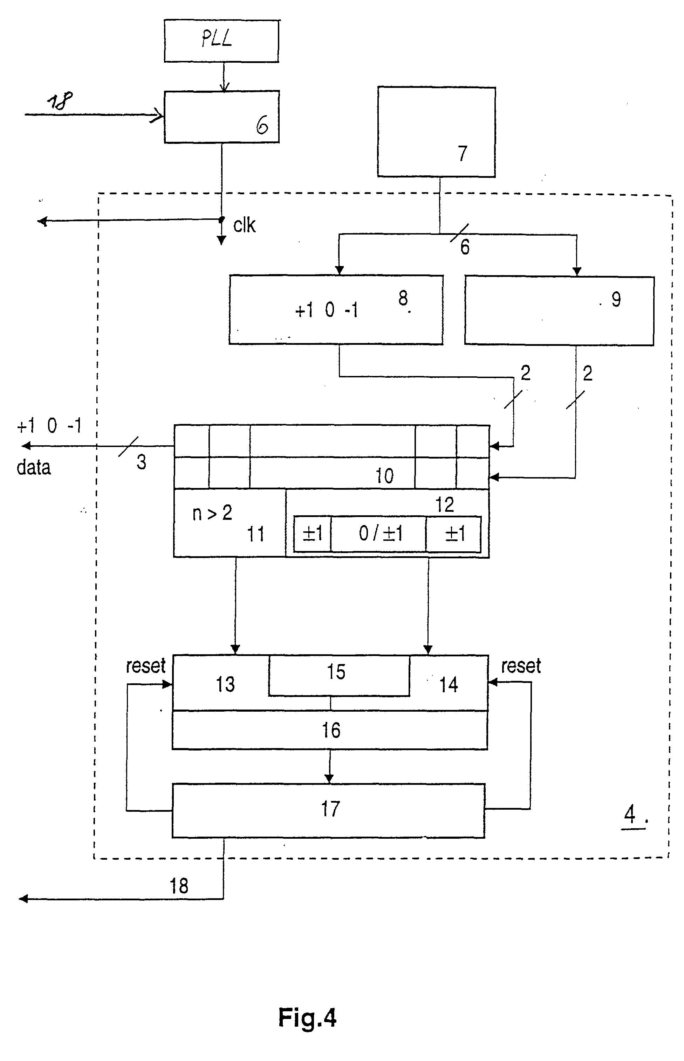

Fig. 4 stellt den Viterbi-Detektor 4 dar. Er bekommt von der PLL-Schaltung PLL ein Clocksignal clk und vom A/D-Wandler 7 jeweils das umgesetzte Signal des hier nicht dargestellten Equalizers 5. Das Signal vom A/D-Wandler 7 wird dem Entscheider 8 und dem Spitzenwertdetektor 9 weitergegeben. Im Entscheider 8 wird durch Amplitudenauswertung die Entscheidung für +1; -1 und 0 getroffen. Die beiden Ausgänge werden 2 Überwachungsschieberegistern in der Baugrupe 10 zugeführt. Der Spitzendetektor 9 mißt die Pegel und markiert die Übergänge mit der geringsten Wahrscheinlichkeit (z.B. zum Zeitpunkt n+2 in Fig. 1) nach +1 und -1 Übergängen getrennt. Diese Markierungsbits werden synchron mit den Entscheiderbits getrennten Überwachungsschieberegistern in der Baugruppe 10 zugeführt. Im Vergleicher 12 werden die unerlaubten Übergänge
+1>>0>>+1; -1>>0>>-1; +1>>-1>>+1; -1>>+1>>-1
detektiert und korrigiert, wobei der Inhalt der **Überwachungsschieberegister** verändert wird. Der Zähler 11 ermittelt die Anzahl der aufeinanderfolgenden +1 bzw. -1 Pegel. Ein Wert >2 deutet, gemäß der Vorkodierung, auf einen Fehler hin.

Die Baugruppen 13 - 17 zeigen die erfindungsgemäße Lösung für die den jeweiligen Flankenwechseln zugeordneten Korrekturen für einen iterativen Vorgang.

Der Flankenkorrekturzähler 15, der sich zusammensetzt aus dem Korrekturzähler 13 für linke Flanken und Korrekturzähler 14 für rechte Flanken zählt die pro Zeiteinheit (z.B. Anzahl von Taktzyklen) auftretenden Korrekturen. Der Vergleicher 16 ermittelt die **Korrekturrichtung** und startet oder beendet den Vorgang durch Zählung der absoluten Korrekturen. In der Baugruppe 17 wird das Ausgabesignal bereitgestellt, sowie die Flankenzählung nach der Ausgabe zurückgesetzt.

Beide Einheiten geben das ausgewertete Signal auf ein Überwachungsschieberegister 10. Das Überwachungsschieberegister 10 ist verbunden mit dem Zähler 11 und dem Vergleicher 12. Der Zähler 11 gibt seine Auswertung an die linke Flanke 13 und der Vergleicher 12 seine Auswertung an die rechte Flanke 14 weiter. Die linke Flanke 13 und die rechte Flanke 14 beinhalten einen Flankenkorrekturzähler 15 und diese drei Einheiten sind in einem nächsten Vergleicher 16 zusammengefaßt. Der Vergleicher 16 ist verbunden mit dem Phasenschiebe**regler** 17 der jeweils ein Resetsignal weitergibt. Der Phasenschieberegler 17 hat **einen Ausgang 18 über den er die Verzögerungsleitung einstellt.**

## Patentansprüche

1. Vorrichtung zur Wiedergewinnung von digitalen Daten aus einem aufgezeichnetem Signal mit einer Taktrückgewinnungsstufe, mit einer getakteten Abtaststufe (7) und einem Viterbi-Detektor (4) als Entscheiderstufe, **dadurch gekennzeichnet, daß** die Taktrückgewinnungsstufe eine PLL-Schaltung (PLL) enthält, die auf Signalflankenwechsel des wiedergegebenen Aufzeichnungssignal anspricht, daß weiterhin eine schaltbare Verzögerungsleitung (6) vorgesehen ist, der das von der PLL-Schaltung ausgegebene Taktsignal zugeführt ist, und daß der Viterbi-Detektor (4) so ausgebildet ist, daß er über einen Eingang das verzögerte Taktsignal von der Verzögerungsleitung (6) erhält, daß er über einen weiteren Eingang das in der getakteten Abtaststufe (7) umgesetzte aufgezeichnete Signal erhält, daß er weiterhin aufweist, eine Entscheiderstufe (8) die entscheidet, welches von einer Anzahl möglicher Werte einem Abtastwert zuzuordnen ist, eine Fehlerkorrekturstufe (12), zur Markierung und Korrektur von fehlerhaften Abtastwerten, Zählmittel (13, 14, 15) zur Zählung auftretender Korrekturen und einen Phasenschieberegler (17) zur Erzeugung von Phasensteuersignalen (18), wenn die Fehlerrate einen vorgegebenen Wert überschreitet, wobei die Phasensteuersignale der schaltbaren Verzögerungsleitung (6) zugeführt sind.

2. Vorrichtung nach Anspruch 1, wobei die Zählmittel (13, 14, 15) aufweisen, Zählmittel (13, 14) zur separaten Zählung von auftretenden Korrekturen nach linken und rechten Signalflanken des wiedergegebenen Aufzeichnungssignals getrennt, Vergleichsmittel (16) zur Vergleichung der Zählwerte für fehlerhafte linke und rechte Signalflanken zur Bestimmung der Richtung der Phasenverschiebung für eine Phasenkorrektur.

## Claims

1. Apparatus for recovering digital data from a recorded signal including a clock recovery stage, a gated sampling stage (7) and a Viterbi detector (4) working as a decision device,
**characterized in that**
the clock recovery stage includes a PLL circuit (PLL) responsive to signal edge changes of the reproduced recording signal, that furthermore a switchable delay line (6) is provided being fed by the clock signal issued by the PLL circuit, and that the Viterbi detector (4) is designed in such a way that it receives the delayed clock signal from the delay line (6) via an input, that it receives the recorded signal converted in the clocked sampling stage (7) via a further input, that it furthermore includes a decision device (8) deciding which of a number of possible values has to be assigned to a sampling value, an error correction stage (12) for marking and correcting erroneous sampling values, counting means (13, 14, 15) for counting appearing correction values and a phase shifter controller (17) for generating phase shifter signals (18) if the error rate exceeds a predetermined value, wherein the phase control signals are supplied to the switchable delay line (6).

2. Apparatus according to claim 1, wherein the counting means (13, 14, 15) include counting means (13, 14) for counting separately appearing corrections separately for left and right signal edges of the reproduced record signal, comparing means (16) for comparing the count values for erroneous left and right signal edges for determining the direction of phase shift for a phase correction.

## Revendications

1. Dispositif de récupération de données numériques à partir d'un signal enregistré, avec un étage de resynsychronisation de l'impulsion, un étage échantillonneur (7) et un détecteur Viterbi (4) comme étage de décision, **caractérisé en ce que** l'étage de resynsychronisation de l'impulsion contient un circuit PLL (PLL) qui répond aux changements de flanc du signal d'enregistrement reproduit, **en ce qu'**ensuite un circuit de retard (6) commutable est prévu, lequel achemine le signal d'impulsion produit par le circuit PLL et **en ce que** le détecteur Viterbi (4) est configuré de sorte qu'il reçoit le signal d'impulsion retardé du circuit de retard (6) via une entrée, qu'il reçoit le signal enregistré converti dans l'étage échantillonneur (7) synchronisé, **en ce qu'**il présente en outre un étage de décision (8) qui décide quelle valeur parmi un certain nombre de valeurs possibles doit être associée à une valeur d'échantillonnage, qu'il présente un étage de correction d'erreurs (12) pour marquer et corriger des valeurs d'échantillonnage erronées, qu'il présente des dispositifs de comptage (13, 14, 15) pour compter les corrections survenant et qu'il présente un correcteur de déphasage (17) pour produire des signaux de commande de phase (18) lorsque le taux d'erreurs dépasse une valeur préalablement fixée, où les signaux de commande de phase sont acheminés au circuit de retard commutable (6).

2. Dispositif conforme à la revendication 1, **caractérisé en ce que** les dispositifs de comptage (13, 14, 15) présentent des dispositifs de comptage (13, 14) pour le décompte séparé de corrections survenant après les flancs gauches et droites du signal d'enregistrement reproduit, des dispositifs de comparaison (16) pour comparer les valeurs de comptage pour les flancs de signaux gauches et droites erronés, afin de déterminer le sens du déphasage pour une correction de phase.
